# EUROPÄISCHE PATENTSCHRIFT

(11) **EP 0 483 722 B1**
(45) Veröffentlichungstag und Bekanntmachung des Hinweises auf die Patenterteilung: **11.01.1995**
(21) Anmeldenummer: 91118346.5
(22) Anmeldetag: 28.10.1991
(51) Int. Cl.: C08F 38/00

(54) **Verfahren zur Polymerisation teilweise fluorierter Kohlenwasserstoffe, die eine Dreifachbindung aufweisen**
Process for polymerization of partly fluorinated hydrocarbons containing a triple bond
Procédé de polymérisation d'hydrocarbures partiellement fluorés contenant une liaison triple

(30) Priorität: 02.11.1990 DE 4034823
(43) Veröffentlichungstag der Anmeldung: 06.05.1992
(73) Patentinhaber: HOECHST AKTIENGESELLSCHAFT, 65926 Frankfurt am Main (DE)
(72) Erfinder: Von Werner, Konrad, Dr., W-8268 Garching (DE); Weiss, Karin, Dr., W-8580 Bayreuth (DE)

(56) Entgegenhaltungen:
- PATENT ABSTRACTS OF JAPAN, vol. 13, no. 95 (C-573)(3443), 6. März 1989; & JP-A-63 273 610
- CHEMICAL ABSTRACTS, vol. 99, no. 18, Oktober 1983, Columbus, Ohio, US; abstract no. 140600Q; MITSUBISHI CHEMICAL INDUSTRIES CO.:"POLY(DIFLUOROACETYLENES)", Seite 13, Spalte 2

## Beschreibung

Die Erfindung betrifft ein Verfahren zur Polymerisation teilweise fluorierter Kohlenwasserstoffe, die eine Dreifachbindung aufweisen, mit Wolfram enthaltenden Katalysatoren.

Die Polymerisation von nicht fluorierten Kohlenwasserstoffen, die eine C C-Dreifachbindung aufweisen, mit Wolfram enthaltenden Komplexverbindungen als Katalysatoren ist von T. J. Katz et al. in J. Am. Chem. Soc., 102 (1980), Seiten 422 bis 424 und J. Am. Chem. Soc., 106 (1984), Seiten 2 659 bis 2 668 sowie von K. Weiß in "Carbyne Complexes", VCH-Verlag, Weinheim, 1988, Seiten 217 bis 219 beschrieben.

Bekannt ist ferner die Umsetzung von Phenylacetylen, dessen Phenylrest mit einem Fluoratom oder einer CF₃-Gruppe substituiert ist, mit W(CO)₆ in Tetrachlormethan unter Einwirkung von Licht, wobei lösliche Polymere mit einer gewichtsmittleren Molmasse von 1,1 · 10⁴ bis 159 · 10⁴ erhalten werden [siehe H. Muramatsu, T. Ueda und K. Itoh, Macromolecules, 18 (1985), Seite 1 634].

Über die Umsetzung von perfluoralkylsubstituierten Alkinen ist bisher nichts bekannt.

Aufgabe der vorliegenden Erfindung ist es, ein Verfahren bereitzustellen, mit dem perfluoralkylsubstituierte Alkine bestimmter Zusammensetzung polymerisiert werden können, wobei weitgehend unlösliche Polymere entstehen, die konjugierte C=C-Doppelbindungen aufweisen.

Diese Aufgabe wird gelöst durch ein Verfahren zur Polymerisation von substituierten Kohlenwasserstoffen, die eine C≡C-Dreifachbindung aufweisen, mit Wolfram enthaltenden Katalysatoren unter Bildung von Polymeren, die mehrere konjugierte C=C-Doppelbindungen aufweisen, bei 0 bis 150 °C, falls erforderlich in Gegenwart eines inerten Lösungsmittels, unter normalem Atmosphärendruck oder dem autogenen Druck der Reaktionsmischung, das dadurch gekennzeichnet ist, daß zur Umsetzung mindestens eine Verbindung der Formel

R_{f}-(CH₂)ₙ-C≡C-R' (I)

eingesetzt wird, in der bedeuten
- R_{f}: einen geradkettigen, verzweigten oder cyclischen Perfluoralkylrest mit 1 bis 12 C-Atomen,
- n: eine ganze Zahl von 1 bis 10 und
- R': ein H-Atom, einen Alkylrest mit 1 bis 4 C-Atomen, einen β- bis ω-Hydroxyalkylrest mit 2 bis 4 C-Atomen, einen Trialkylsilylrest mit 1 bis 4 C-Atomen in jeder Alkylgruppe, einen Phenyl- oder Naphthylrest, der seinerseits mit 1 bis 3 Alkylgruppen substituiert sein kann, wobei diese Alkylgruppen je 1 bis 4 C-Atome aufweisen, den Benzylrest oder den Rest R_{f}-(CH₂)ₙ-, worin R_{f} und n die obengenannte Bedeutung haben.

Zur Durchführung des erfindungsgemäßen Verfahrens geeignete Verbindungen der Formel (I) sind beispielsweise:
(CF₃)₂CF-(CH₂)₂-C≡CH
C₈F₁₇-(CH₂)₃-C≡CH
C₆F₁₃-(CH₂)₂-C≡CH
C₆F₁₃-(CH₂)₄-C≡C-C₂H₅ 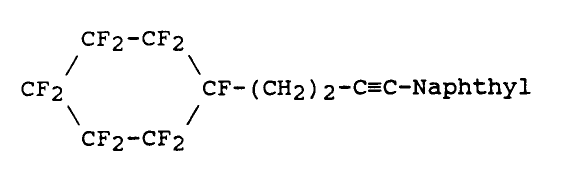
C₄F₉-(CH₂)₆-C≡C-C(CH₃)₃
C₆F₁₃-(CH₂)₂-C≡C-CH₂CH₂OH
C₈F₁₇-(CH₂)₄-C≡C-Si(CH₃)₃
C₆F₁₃-(CH₂)₂-C≡C-Phenyl
C₄F₉-(CH₂)₆-C≡C-Tolyl
C₆F₁₃-(CH₂)₂-C≡C-(CH₂)₂-C₆F₁₃

Die Herstellung dieser Verbindungen kann beispielsweise aus den entsprechenden Alkenverbindungen durch Anlagerung von Brom und anschließende Abspaltung von Bromwasserstoff sowie auch nach anderen Methoden erfolgen.

Es können mehrere Verbindungen der Formel (I) eingesetzt werden. Bevorzugt werden Verbindungen der Formel (I) eingesetzt, in denen R_{f} eine Perfluoralkylgruppe mit 2 bis 10 C-Atomen, insbesondere mit 3 bis 8 C-Atomen, ist. Ferner sind bevorzugt solche Verbindungen der Formel (I), in denen R' = H, Methyl, Ethyl, β-Hydroxyethyl, Trimethylsilyl, Phenyl oder Tolyl ist. Insbesondere werden solche Verbindungen der Formel (I) eingesetzt, in den R' = H, Phenyl oder Trimethylsilyl ist.

Wegen ihrer guten Zugänglichkeit und Reaktionsfähigkeit sind ferner Verbindungen der Formel (I) bevorzugt, in denen n eine ganze Zahl von 2 bis 4 ist. Weiterhin sind Verbindungen der Formel (I) bevorzugt, in denen R' den Rest R_{f}(CH₂)n- und n eine Zahl von 1 bis 4 bedeutet. Der Rest R_{f} hat die gleiche Bedeutung wie weiter oben angegeben.

Die erfindungsgemäße Umsetzung findet in Gegenwart Wolfram enthaltender Katalysatoren statt. Gut geeignet sind hierzu beispielsweise Komplexverbindungen der Formel 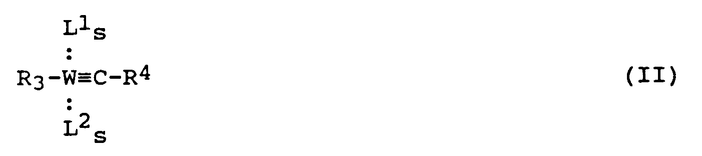
in der bedeuten
- R: = Cl, -CH₂-C(CH₃)₃, -O-C(CH₃)₃, -S-C(CH₃)₃ oder -NG₂, worin G eine Alkylgruppe mit 1 bis 4 C-Atomen oder der Benzylrest ist,
- R⁴: eine geradkettige, verzweigte oder cyclische Alkylgruppe mit 1 bis 6 C-Atomen, eine Trialkylsilylgruppe, deren Alkylreste je 1 bis 3 C-Atome enthalten, eine Benzyl-, Phenyl-, Tolyl- oder Naphthylgruppe,
- L¹: ein Trialkylphosphin, Trialkylphosphinoxid oder Ethylenglykoldialkylether, deren Alkylgruppen 1 bis 4 C-Atome aufweisen,
- L²: ein Trialkylphosphin, Trialkylphosphinoxid, Trialkylphosphoniumchlorid oder Tetraalkylammoniumchlorid, deren Alkylgruppen 1 bis 4 C-Atome aufweisen, mit der Maßgabe, daß R = Cl ist, wenn L² ein Trialkylphosphonium oder Tetraalkylammoniumchlorid ist, und
- s: = Null oder 1.

Beispiele für solche Wolfram enthaltenden Katalysatoren sind:
(CH₃OCH₂CH₂OCH₃)Cl₃W≡C-C(CH₃)₃
[(CH₃)₃C-CH₂-]₃W≡C-C(CH₃)₃
[(CH₃)₃C-O-]₃W≡C-C(CH₃)₃
[(CH₃)₃C-S-]₃W≡C-C(CH₃)₃
[(CH₃)₂N-]₃W≡C-C(CH₃)₃
[(CH₃)₃P]Cl₃W≡C-C(CH₃)₃
[(C₂H₅)₃P]Cl₃W≡C-C(CH₃)₃
[(C₂H₅)₃PO]Cl₃W≡C-C(CH₃)₃
[(C₂H₅)₃P][(C₂H₅)₃PO]Cl₃W≡C-C(CH₃)₃
[(C₂H₅)₃PH]⁺ [Cl₄W≡C-C(CH₃)₃]⁻
[(C₂H₅)₄N]⁺ [Cl₄W≡C-C(CH₃)₃]⁻ 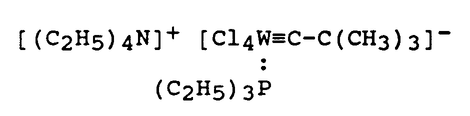
(CH₃OCH₂CH₂OCH₃)Cl₃W≡C-CH₃ 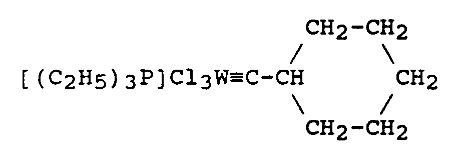
[(CH₃)₃P]Cl₃W≡C-CH₂-Phenyl
[(CH₃)₃C-CH₂]₃-W≡C-Phenyl
[(CH₃)₃C-CH₂]₃-W≡C-Si(CH₃)₃
Die Herstellung solcher Wolfram-Komplexverbindungen ist beschrieben von R. R. Schrock, D. N. Clark, I. Sancho, I. H. Wengrovius, S. M. Rocklage und S. F. Pedersen in "Organometallics", 1 (1982), Seiten 1 645 bis 1 650.

Weitere geeignete Wolfram-Komplexverbindungen sind beispielsweise solche der Formel

(CO)_{y}QW≡C-R⁵ (III)

worin bedeuten
- Q: = Cl, Br, I und
- y: = 4
oder
- Q: = Cyclopentadienyl und
- y: = 2 sowie
- R⁵: eine geradkettige, verzweigte oder cyclische Alkylgruppe mit 1 bis 6 C-Atomen, Phenyl, Naphthyl oder -NT₂, worin T eine Alkylgruppe mit 1 bis 4 C-Atomen ist.

Beispiele für geeignete Verbindungen sind:
(CO)₄ClW≡C-Phenyl
(CO)₄BrW≡C-Phenyl
(CO)₂-Cyclopentadienyl-W≡C-Phenyl
(CO)₄ClW≡C-C₂H₅
(CO)₂-Cyclopentadienyl-W≡C-N(CH₃)₂
Die Herstellung dieser Wolfram-Komplexverbindungen ist beschrieben von O. E. Fischer et al., "Angewandte Chemie", 85 (1973), Seiten 618 bis 620.

Die genannten Wolfram-Komplexverbindungen können als solche zu den flüssigen Verbindungen der Formeln (I) und/oder (II) sowie auch zu deren flüssigen Mischungen mit einer oder mehreren Verbindung(en) der Formel (III) gegeben werden. Vorzugsweise werden jedoch Lösungsmittel zugesetzt. Geeignet sind hier flüssige, gesättigte Kohlenwasserstoffe, wie Hexan, Heptan, Octan, deren Isomeren-Gemische sowie deren Chlor- beziehungsweise Fluor-Substitutionsprodukte, wie Propylchlorid, Butylchlorid, Cyclohexylchlorid, Dichlormethan, Dichlorethan, Dichlorpropan, Chloroform, Trichlorethan, Tetrachlormethan, Trichlorfluormethan und Trichlortrifluorethan.

Neben den Wolfram-Verbindungen können zusätzlich als Cokatalysatoren Metallalkyle, wie Sn(CH₃)₄, Alkylmetallhalogenide, wie (C₂H₅)₂AlCl, Metallhalogenide, wie SnCl₄, TiCl₄, und aliphatische Alkohole oder Phenole eingesetzt werden.

Ferner sind gut geeignete Katalysatoren solche, die aufgebaut sind aus einem festen Träger, der im wesentlichen aus Siliciumdioxid, Aluminiumoxid oder Mischungen dieser beiden Oxide besteht, an dem über Sauerstoffatome der genannten Oxide oder über Chrom, das an diese Sauerstoffatome gebunden ist, eine Wolfram-Komplexverbindung, die eine Bindung zwischen Wolfram und einem Kohlenstoffatom aufweist, gebunden ist.

Es wird angenommen, daß sich hierbei folgende Strukturen bilden:

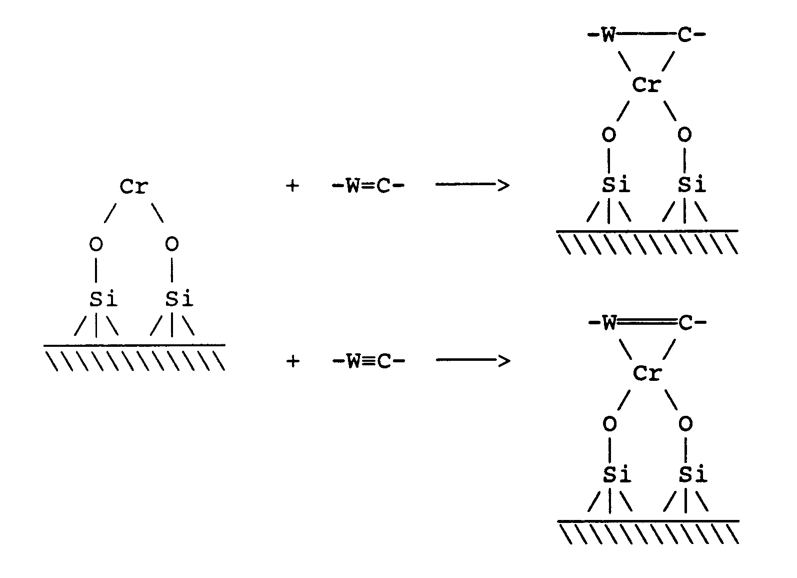

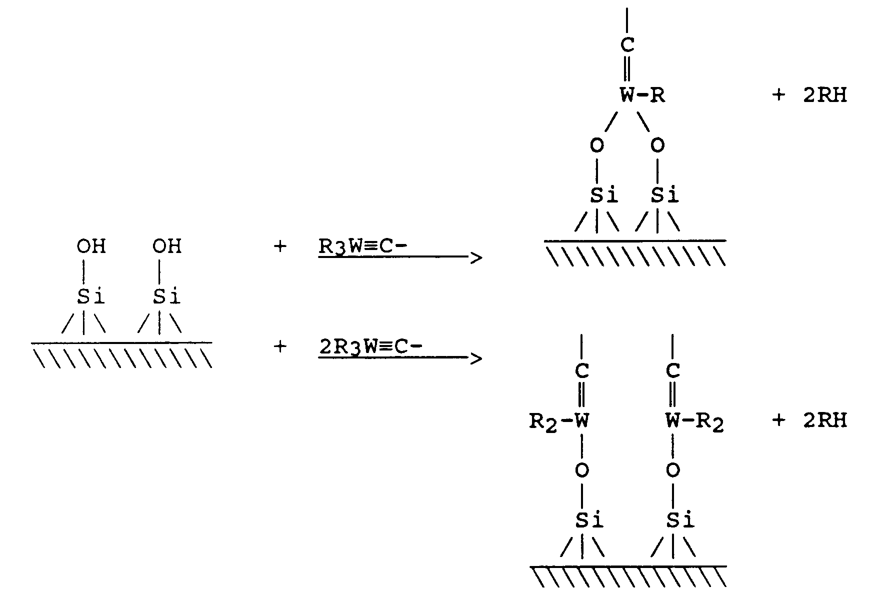

Als Wolfram-Verbindungen des Typs -W≡C- beziehungsweise R₃W≡C- sind gut geeignet die weiter oben näher beschriebenen Verbindungen der Formeln (II) und (III), die durch die Bindung an den festen Träger besser lagerfähig werden. Solche Katalysatoren sind beschrieben von K. Weiß und G. Lößel in "Angewandte Chemie", 101 (1989), Seiten 75 bis 77 sowie von K. Weiß und M. Denzner in "Journal of Organometallic Chemistry", 355 (1988), Seiten 273 bis 280.

Ferner sind als Wolfram-Verbindungen des Typs -W=C-beispielsweise Verbindungen folgender Formel geeignet

(CO)₅W=CR¹R² (IV)

in der bedeuten
- R¹: Alkyl mit 1 bis 10 C-Atomen, Benzyl, Phenyl oder Naphthyl, wobei der aromatische Ring dieser Reste seinerseits mit 1 bis 3 Alkylgruppen substituiert sein kann, die ihrerseits zusammen 1 bis 12 C-Atome aufweisen, und
- R²: Alkyl mit 1 bis 10 C-Atomen, Alkoxy mit 1 bis 6 C-Atomen, Benzyl, Phenyl oder Naphthyl, Phenoxy oder Naphthoxy, wobei der aromatische Ring dieser Reste seinerseits mit 1 bis 3 Alkylgruppen subsitituiert sein kann, die ihrerseits zusammen 1 bis 12 C-Atome aufweisen.

Bei der Reaktion der Verbindungen der Formel (IV) mit dem Chrom(II) enthaltenden festen Träger, der im wesentlichen aus Siliciumdioxid, Aluminiumoxid oder Mischungen dieser beiden Oxide besteht, wird CO abgespalten, so daß Verbindungen der Formel 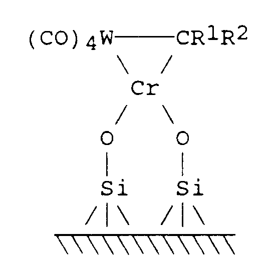
entstehen. Die Herstellung solcher fester Katalysatoren ist beschrieben von K. Weiß, W. Guthmann und S. Maisuls in "Angewandte Chemie", 100 (1988), Seiten 268 bis 270.

In den vorangegangenen Ausführungen umfaßt der Begriff "Siliciumdioxid, Aluminiumoxid oder Mischungen dieser beiden Oxide" nicht nur physikalische Mischungen, sondern auch chemisch verbundene Mischoxide beziehungsweise Alumosilicate.

Die in den vorstehenden Abschnitten beschriebenen, aus festen Trägern aufgebauten Katalysatoren können als solche verwendet werden, wie auch in kleinen Partikeln in Lösungsmitteln, beispielsweise den weiter oben beschriebenen Kohlenwasserstoffen, die chloriert oder fluoriert sein können, suspendiert.

Im allgemeinen werden auf 100 mol einer oder mehrerer Verbindung(en) der Formel (I) 0,01 bis 2 mol, vorzugsweise 0,1 bis 1 mol, Wolfram-Verbindung im Katalysator eingesetzt, jedoch kann insbesondere bei Verwendung von Katalysatoren, die aus festen Trägern aufgebaut sind, die Menge der Wolfram-Verbindung auch über 2 mol je 100 mol Verbindung(en) der Formel (I) betragen. Das Mischungsverhältnis der Verbindungen der Formel (I) untereinander kann in weiten Grenzen schwanken.

Die erfindungsgemäße Umsetzung wird bei 0 bis 150 °C durchgeführt, unter 0 °C verläuft die Umsetzung im allgemeinen zu langsam, oberhalb 150 °C können unerwünschte Nebenprodukte gebildet werden. Die Wahl einer optimalen Temperatur hängt von der thermischen Stabilität der eingesetzten Ausgangsstoffe und Katalysatoren sowie der zu erzielenden Endprodukte ab. Vorteilhaft werden Temperaturen von 10 bis 120 °C und insbesondere von 20 bis 90 °C angewendet.

Im allgemeinen wird bei normalem Atmosphärendruck oder dem autogenen Druck der Reaktionsmischung gearbeitet. Zweckmäßig wird ein trockenes Inertgas, beispielsweise Stickstoff oder Argon, als Schutzgas verwendet.

Die Zeit für die erfindungsgemäße Umsetzung kann in weiten Grenzen schwanken. Sie hängt von den Ausgangsprodukten, dem Katalysator und der Reaktionstemperatur ab. Im allgemeinen ist die Umsetzung beendet, wenn kein in der Reaktionsmischung unlösliches Polymeres mehr entsteht. Bei diskontinuierlicher Arbeitsweise sind Reaktionszeiten von 5 bis 100 Stunden meist ausreichend.

Das Reaktionsgemisch wird während der erfindungsgemäßen Umsetzung zweckmäßig ständig gut durchmischt, insbesondere wenn ein feinteiliger fester Katalysator eingesetzt wird. Diese Durchmischung kann beispielsweise durch Rühren, Kneten, Schütteln, Umpumpen, Sieden des Lösungsmittels oder Leiten eines Inertgases durch die Reaktionsmischung bewirkt werden.

In der Regel wird die Wolfram enthaltende Verbindung sowie, wenn erforderlich, das Lösungsmittel vorgelegt, das Alkin unter Rühren zugegeben und auf Reaktionstemperatur erwärmt.

In machen Fällen empfiehlt es sich, nicht die gesamte Katalysatormenge vor Beginn der Reaktion einzusetzen, sondern nur einen Teil, beispielsweise 5 bis 20 Gew.-% der Gesamtmenge, und den Rest kontinuierlich oder portionsweise zu der Reaktionsmischung zu geben. Während der Reaktion verfärbt sich die Reaktionsmischung in der Regel nach rot bis rotbraun, nach einiger Zeit beginnt meistens das entstandene Polymere auszufallen.

Nach Beendigung der Reaktion wird das Gemisch auf Raumtemperatur gebracht, zweckmäßig mit einer leicht siedenden organischen Flüssigkeit, die mit dem für die Reaktion verwendeten Lösungsmittel mischbar ist, beispielsweise einem Alkanol, versetzt, das ausgefallene Polymere beispielsweise durch Filtrieren oder Zentrifugieren abgetrennt, mit einer kleineren Menge der zugesetzten organischen Flüssigkeit gewaschen und getrocknet. Die Waschflüssigkeit wird mit der abgetrennten Reaktionsflüssigkeit vereinigt und aus der Mischung die leichter flüchtigen Bestandteile, in der Regel das für die Reaktion eingesetzte Lösungsmittel, die zugesetzte organische Flüssigkeit und das nicht umgesetzte Ausgangsprodukt, verdampft, wobei zweckmäßigerweise stark verminderter Druck, beispielsweise 20 bis 200 Pa, angewendet und die Temperatur langsam gesteigert wird. Der verbleibende Rückstand ist ein weiterer Teil des Polymeren, der nach seiner Isolierung ebenso wie das schon bei der Reaktion ausgefallene Polymere in praktisch allen gängigen Lösungsmitteln unlöslich ist, wodurch die Anwendung einer Reihe analytischer Untersuchungsmethoden wie auch gängiger Molmassen- beziehungsweise Kettenlängenbestimmungen nicht möglich ist. Das entstandene Polymere ist in der Regel rot gefärbt und enthält nach Infrarot-Spektralanalyse C=C-Doppelbindungen (Bande bei 1625 cm⁻¹), die konjugiert sind, wie es bei der Polymerisation von Alkinen zu erwarten ist und es die Färbung des Polymeren bestätigt.

Die verdampften flüchtigen Anteile enthalten hauptsächlich das eingesetzte Lösungsmittel, die zugesetzte organische Flüssigkeit und das Ausgangsprodukt. Sie können nach Kondensation und gegebenenfalls Reinigung, beispielsweise durch fraktionierte Destillation, vorteilhaft unter vermindertem Druck, für eine erneute erfindungsgemäße Reaktion eingesetzt werden.

Die erfindungsgemäß erzeugten Polymere können als chemisch beständige, vernetzbare Elastomere verwendet werden, beispielsweise zur Herstellung gas- oder lösungsmitteldurchlässiger Membranen, für Fotowiderstände oder für lichtempfindliche Schichten (Photoresists). Nach Umsetzung der im Polymeren vorhandenen C=C-Doppelbindungen, beispielsweise Chlorierung, Fluorierung oder Hydrierung, können Polymere mit hellerer Farbe sowie verbesserter Beständigkeit erhalten werden, die für weitere Anwendungen geeignet sind.

Nachstehende Beispiele sollen die Erfindung näher erläutern.

### Beispiel 1

In einem Glaskolben von 50 ccm Inhalt werden unter trockenem Stickstoff 10 ccm Dichlormethan und 40 mg (0,089 mmol) der Verbindung (CH₃OCH₂CH₂OCH₃)Cl₃W≡C-C(CH₃)₃ gegeben, auf 25 °C erwärmt und 2,2 ccm (8,9 mmol) 4-Perfluorhexyl-1-butin unter Rühren zugesetzt. Je 100 mol Fluor enthaltender Verbindung wird 1 mol Katalysator eingesetzt. Die Reaktionsmischung verfärbt sich und nach einiger Zeit bildet sich ein unlöslicher Niederschlag. Nach 24 Stunden Rühren bei 25 °C werden 20 ccm Methanol zugesetzt, die gesamte Mischung filtriert, der Filterrückstand mit etwas Methanol gewaschen, die Waschflüssigkeit mit dem Filtrat vereinigt und die flüchtigen Anteile bei einem Druck von 40 Pa unter langsamer Erwärmung bis 30 °C aus der Flüssigkeit entfernt. Es hinterbleiben 0,1 g eines festen, rot gefärbten, gummiartigen Rückstandes, der in allen üblichen Lösungsmitteln unlöslich ist. Als Filterrückstand werden nach Trocknung 2,48 g eines rot gefärbten, gummiartigen Produktes erhalten, das ebenfalls in den üblichen Lösungsmitteln unlöslich ist. Nach infrarotspektrographischer Analyse enthalten diese Rückstände konjugierte C=C-Doppelbindungen. Die Gesamtausbeute, bezogen auf eingesetztes 4-Perfluorhexyl-1-butin, beträgt 78 Gew.-%. Die aus dem Filtrat abgedampften flüchtigen Anteile werden kondensiert und gaschromatographisch untersucht. Sie enthalten neben Dichlormethan und Methanol das Ausgangsprodukt 4-Perfluorhexyl-1-butin.

### Beispiel 2

Es wird verfahren, wie in Beispiel 1 beschrieben, jedoch werden 60 mg (0,12 mmol) der Verbindung [(CH₃)₃C-CH₂]₃W≡C-C(CH₃)₃ und 3,2 ccm (12,8 mmol) 4-Perfluorhexyl-1-butin eingesetzt. Je 100 mol Fluor enthaltender Verbindung werden 0,94 mol Katalysator verwendet. Als getrockneter Filterrückstand werden 4,31 g und als getrockneter Filtratrückstand werden 0,07 g rotes, gummiartiges, in üblichen Lösungsmitteln unlösliches Polymeres erhalten. Die Gesamtausbeute, bezogen auf 4-Perfluorhexyl-1-butin, beträgt 92 Gew.-%.

### Beispiel 3

Es wird wiederum verfahren, wie in Beispiel 1 beschrieben, jedoch werden 30 mg (0,06 mmol) der Verbindung [(CH₃)₃C-O]₃W≡C-C(CH₃)₃ und 1,6 ccm (6,3 mmol) 4-Perfluorhexyl-1-butin eingesetzt. Je 100 mol Fluor enthaltender Verbindung werden 0,95 mol Katalysator verwendet. Als getrockneter Filterrückstand werden 0,42 g und als getrockneter Filtratrückstand werden 0,12 g rotes, gummiartiges, in üblichen Lösungsmitteln unlösliches Polymeres erhalten. Die Gesamtausbeute, bezogen auf 4-Perfluorhexyl-1-butin, beträgt 23 Gew.-%. Die kondensierten Dämpfe aus dem Filtrat enthalten nach gaschromatographischer Analyse neben Dichlormethan und Methanol das Ausgangsprodukt.

### Beispiel 4

Es wird analog Beispiel 1 verfahren, anstelle Dichlormethan wird die gleiche Menge Hexan verwendet. Nach Abkühlung auf 0 °C werden 60 mg (0,13 mmol) der Verbindung (CO)₄BrW≡C-Phenyl und anschließend 3,2 ccm (12,9 mmol) 4-Perfluorhexyl-1-butin zugegeben, dann das Gemisch langsam unter Rühren auf 69 °C erwärmt. Je 100 mol Fluor enthaltender Verbindung wird 1 mol Katalysator verwendet. Bereits nach 4,5 Stunden Rühren bei 69 °C wird auf Raumtemperatur abgekühlt. Dann werden 20 ccm Methanol zugegeben und es wird gearbeitet, wie in Beispiel 1 beschrieben. Als getrockneter Filterrückstand werden 3,43 g und als getrockneter Filtratrückstand werden 0,83 g rotes, gummiartiges, in üblichen Lösungsmitteln unlösliches Polymeres erhalten. Die Gesamtausbeute, bezogen auf eingesetzte, Fluor enthaltende Verbindung, beträgt 88,8 Gew.-%.

### Beispiel 5

Es wird verfahren, wie in Beispiel 4 beschrieben, jedoch werden 35 mg eines festen, feinteiligen Katalysators eingesetzt, der durch Umsetzung eines festen Siliciumdioxid-Chrom(II)-Katalysators mit der Verbindung (CO)₄BrW≡C-Phenyl erhalten wurde, wie in "Journal of Organometallic Chemistry", 355 (1988), Seite 279 beschrieben. Die angewendete Katalysatormenge enthält 0,05 mmol Wolfram-Verbindung. Ferner werden 1,4 ccm (5,9 mmol) 4-Perfluorhexyl-1-butin zugegeben. Auf 100 mol Fluor enthaltender Verbindung werden 0,85 mol Wolfram enthaltende Verbindung verwendet. Temperatur und Reaktionsdauer sind dieselben wie in Beispiel 4. Als getrockneter Filterrückstand werden 0,21 g und als getrockneter Filtratrückstand werden 0,16 g rotes, gummiartiges, in üblichen Lösungsmitteln unlösliches Polymeres erhalten. Die Gesamtausbeute, bezogen auf eingesetzte, Fluor enthaltende Verbindung beträgt 17 Gew.-%. Das kondensierte Filtrat enthält nach gaschromatographischer Analyse neben Hexan und Methanol das Ausgangsprodukt.

## Patentansprüche

1. Verfahren zur Polymerisation von substituierten Kohlenwasserstoffen, die eine C≡C-Dreifachbindung aufweisen, mit Wolfram enthaltenden Katalysatoren unter Bildung von Polymeren, die mehrere konjugierte C=C-Doppelbindungen aufweisen, bei 0 bis 150 °C, falls erforderlich in Gegenwart eines inerten Lösungsmittels, unter normalem Atmosphärendruck oder dem autogenen Druck der Reaktionsmischung, dadurch gekennzeichnet, daß zur Umsetzung mindestens eine Verbindung der Formel
R_{f}-(CH₂)ₙ-C≡C-R' (I)
eingesetzt wird, in der bedeuten
R_{f} einen geradkettigen, verzweigten oder cyclischen Perfluoralkylrest mit 1 bis 12 C-Atomen,
n eine ganze Zahl von 1 bis 10 und
R' ein H-Atom, einen Alkylrest mit 1 bis 4 C-Atomen, einen β- bis ω-Hydroxyalkylrest mit 2 bis 4 C-Atomen, einen Trialkylsilylrest mit 1 bis 4 C-Atomen in jeder Alkylgruppe, einen Phenyl- oder Naphthylrest, der seinerseits mit 1 bis 3 Alkylgruppen substituiert sein kann, wobei diese Alkylgruppen je 1 bis 4 C-Atome aufweisen, den Benzylrest oder den Rest R_{f}-(CH₂)ₙ-, worin R_{f} und n die obengenannte Bedeutung haben.

2. Verfahren nach Anspruch 1, dadurch gekennzeichnet, daß ein Katalysator folgender Formel eingesetzt wird: 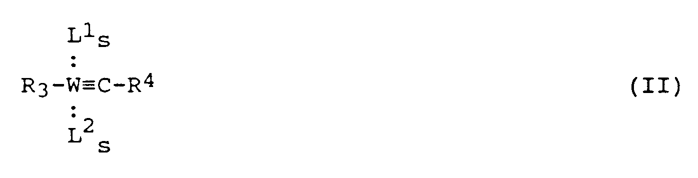 eingesetzt wird, in der bedeuten
R = Cl, -CH₂-C(CH₃)₃, -O-C(CH₃)₃, -S-C(CH₃)₃ oder -NG₂, worin G eine Alkylgruppe mit 1 bis 4 C-Atomen oder der Benzylrest ist,
R⁴ eine geradkettige, verzweigte oder cyclische Alkylgruppe mit 1 bis 6 C-Atomen, eine Trialkylsilylgruppe, deren Alkylreste je 1 bis 3 C-Atome enthalten, eine Benzyl-, Phenyl-, Tolyl- oder Naphthylgruppe,
L¹ ein Trialkylphosphin, Trialkylphosphinoxid oder Ethylenglykoldialkylether, deren Alkylgruppen 1 bis 4 C-Atome aufweisen,
L² ein Trialkylphosphin, Trialkylphosphinoxid, Trialkylphosphoniumchlorid oder Tetraalkylammoniumchlorid, deren Alkylgruppen 1 bis 4 C-Atome aufweisen, mit der Maßgabe, daß R = Cl ist, wenn L² ein Trialkylphosphonium oder Tetraalkylammoniumchlorid ist, und
s = Null oder 1.

3. Verfahren nach Anspruch 1, dadurch gekennzeichnet, daß ein Katalysator folgender Formel eingesetzt wird:
(CO)_{y}QW≡C-R⁵ (III)
in der bedeuten
Q = Cl, Br, I und
y = 4
oder
Q = Cyclopentadienyl und
y = 2 sowie
R⁵ eine geradkettige, verzweigte oder cyclische Alkylgruppe mit 1 bis 6 C-Atomen, Phenyl, Naphthyl oder -NT₂, worin T eine Alkylgruppe mit 1 bis 4 C-Atomen ist.

4. Verfahren nach Anspruch 1, dadurch gekennzeichnet, daß der Katalysator aufgebaut ist aus einem festen Träger, der im wesentlichen aus Siliciumdioxid, Aluminiumoxid oder Mischungen dieser beiden Oxide besteht, an den über O-Atome oder über O-Atome und Chrom das Wolfram als eine Komplexverbindung, die eine Bindung zwischen Wolfram und Kohlenstoff aufweist, gebunden ist.

5. Verfahren nach Anspruch 1, dadurch gekennzeichnet, daß mindestens eine Verbindung der Formel (I) eingesetzt wird, in der bedeutet R' = H, Methyl, Ethyl, β-Hydroxyethyl, Trimethylsilyl, Phenyl oder Tolyl.

6. Verfahren nach Anspruch 1, dadurch gekennzeichnet, daß mindestens eine Verbindung der Formel (I) eingesetzt wird, in der bedeutet R' den Rest R_{f}(CH₂)ₙ- und n eine ganze Zahl von 1 bis 4.

## Claims

1. A process for polymerizing substituted hydrocarbons having a C≡C triple bond using tungsten-containing catalysts to form polymers having a plurality of conjugated C=C double bonds at from 0 to 150°C, if required in the presence of an inert solvent, under normal atmospheric pressure or the autogenic pressure of the reaction mixture, wherein the reaction is carried out using at least one compound of the formula
R_{f}-(CH₂)ₙ-C≡C-R' (I)
where
R_{f} is a straight-chain, branched or cyclic perfluoroalkyl radical having from 1 to 12 carbon atoms,
n is an integer from 1 to 10 and
R' is a hydrogen atom, an alkyl radical having from 1 to 4 carbon atoms, a β- to ω-hydroxyalkyl radical having from 2 to 4 carbon atoms, a trialkylsilyl radical having from 1 to 4 carbon atoms in each alkyl group, a phenyl or naphthyl radical which itself can be substituted by from 1 to 3 alkyl groups, with these alkyl groups each having from 1 to 4 carbon atoms, the benzyl radical or the radical R_{f}-(CH₂)ₙ-, where R_{f} and n are as defined above.

2. The process as claimed in claim 1, wherein the catalyst used has the following formula: 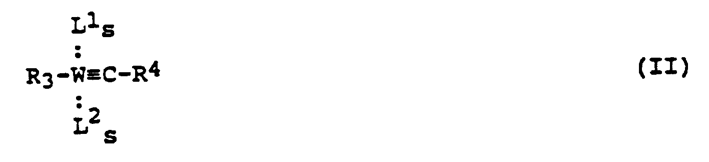 where
R is Cl, -CH₂-C(CH₃)₃, -O-C(CH₃)₃, -S-C(CH₃)₃ or -NG₂, where G is an alkyl group having from 1 to 4 carbon atoms or the benzyl radical,
R⁴ is a straight-chain, branched or cyclic alkyl group having from 1 to 6 carbon atoms, a trialkylsilyl group whose alkyl radicals each contain from 1 to 3 carbon atoms, a benzyl, phenyl, tolyl or naphthyl group,
L¹ is a trialkylphosphine, trialkylphosphine oxide or ethylene glycol dialkyl ether, in each of which the alkyl groups have from 1 to 4 carbon atoms,
L² is a trialkylphosphine, trialkylphosphine oxide, trialkylphosphonium chloride or tetraalkylammonium chloride, in each of which the alkyl groups have from 1 to 4 carbon atoms, with the proviso that R is Cl when L² is a trialkylphosphonium or tetraalkylammonium chloride, and
s = zero or 1.

3. The process as claimed in claim 1, wherein the catalyst used has the following formula:
(CO)_{y}QW≡C-R⁵ (III)
where
Q is Cl, Br, I and
y = 4
or
Q is cyclopentadienyl and
y = 2 and
R⁵ is a straight-chain, branched or cyclic alkyl group having from 1 to 6 carbon atoms, phenyl, naphthyl or -NT₂, where T is an alkyl group having from 1 to 4 carbon atoms.

4. The process as claimed in claim 1, wherein the catalyst is built up of a solid support which consists essentially of silicon dioxide, aluminum oxide or mixtures of these two oxides, to which the tungsten is bound, via O atoms or via O atoms and chromium, as a complex compound which has a bond between tungsten and carbon.

5. The process as claimed in claim 1, wherein use is made of at least one compound of the formula (I) in which R' is H, methyl, ethyl, β-hydroxyethyl, trimethylsilyl, phenyl or tolyl.

6. The process as claimed in claim 1, wherein use is made of at least one compound of the formula (I) in which R' is the radical R_{f}(CH₂)ₙ- and n is an integer from 1 to 4.

## Revendications

1. Procédé pour la polymérisation d'hydrocarbones substitués qui présentent une triple liaison C≡C avec des catalyseurs contenant le tungstène, en formant des polymères, qui présentent plusieurs doubles liaisons C=C, à des températures de 0 à 150 °C, si nécessaire en présence d'un solvant inerte, sous la pression atmosphérique normale ou sous une pression autogène du mélange réactionnel, caractérisé en ce qu'on utilise pour la réaction au moins un composé de formule :
R_{f}-(CH₂)ₙ-C≡C-R' (I)
dans laquelle
R_{f} représente un radical perfluoroalkyle linéaire, ramifié ou cyclique avec 1 à 12 atomes de carbone,
n représente un nombre entier de 1 à 10 et
R' représente un atome H, un radical alkyle avec 1 à 4 atomes de carbone, un radical β- à ω-hydroxyalkyle avec 2 à 4 atomes de carbone, un radical trialkylsilyle avec 1 à 4 atomes de carbone dans chaque groupe alkyle, un radical phényle ou naphtyle qui, de son côté, peut être substitué par 1 à 3 groupes alkyle, ces groupes alkyle présentant chacun 1 à 4 atomes de carbone, le radical benzyle ou le radical R_{f}-(CH₂)ₙ-, où R_{f} et n ont la signification donnée ci-dessus.

2. Procédé selon la revendication 1, caractérisé en ce qu'on utilise un catalyseur de formule suivante : 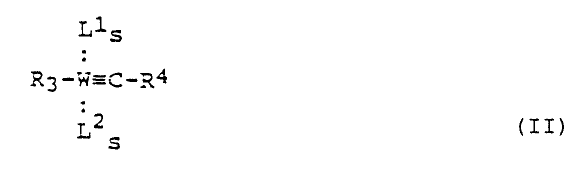 dans laquelle
R représente Cl, -CH₂-C(CH₃)₃, -O-C(CH₃)₃, -S-C(CH₃)₃ ou -NG₂, où G représente un groupe alkyle avec 1 à 4 atomes de carbone ou le radical benzyle,
R⁴ un groupe alkyle linéaire, ramifié ou cyclique avec 1 à 6 atomes de carbone, un groupe trialkylsilyle, dont les radicaux alkyle contiennent chacun 1 à 3 atomes de carbone, un groupe benzyle, phényle, tolyle ou naphtyle,
L¹ représente un trialkylphosphine, un oxyde de trialkylphosphine ou un éther dialkylique de l'éthylène-glycol, dont les groupes alkyle présentent 1 à 4 atomes de carbone,
L² représente un trialkylphosphine, un oxyde de trialkylphosphine, un chlorure de trialkylphosphonium ou un chlorure de tétraalkylammonium dont les groupes alkyle présentent 1 à 4 atomes de carbone, à la condition que R = Cl, lorsque L² représente un trialkylphosphonium ou un chlorure de tétraalkylammonium et
s vaut 0 ou 1.

3. Procédé selon la revendication 1, caractérisé en ce qu'on utilise un catalyseur de formule suivante :
(CO)_{y}QW≡C-R⁵ (III)
dans laquelle
Q représente Cl, Br, I et
y vaut 4
ou
Q représente le cyclopentadiényle et
y vaut 2 ainsi que
R⁵ représente un groupe alkyle linéaire, ramifié ou cyclique avec 1 à 6 atomes de carbone, un phényle, un naphtyle ou -NT₂, où T représente un groupe alkyle avec 1 à 4 atomes de carbone.

4. Procédé selon la revendication 1, caractérisé en ce que le catalyseur est constitué essentiellement d'un support solide composé de dioxyde de silicium, d'oxyde d'aluminium ou des mélanges de ces deux oxydes, auquel, par l'intermédiaire des atomes d'oxygène ou par l'intermédiaire des atomes d'oxygène et du chrome, est lié le tungstène en tant que composé complexe qui présente une liaison entre le tungstène et le carbone.

5. Procédé selon la revendication 1, caractérisé en ce qu'on utilise au moins un composé de formule (I), dans laquelle R' = H, le méthyle, l'éthyle, le β-hydroxyéthyle, le triméthylsilyle, le phényle ou le tolyle.

6. Procédé selon la revendication 1, caractérisé en ce qu'on utilise au moins un composé de formule (I), dans laquelle R' représente le radical R_{f}(CH₂)ₙ- et n un nombre entier de 1 à 4.
